# FASCICULE DE BREVET EUROPEEN

(11) **EP 3 654 394 B1**
(45) Date de publication et mention de la délivrance du brevet: **11.08.2021**
(21) Numéro de dépôt: 19208513.2
(22) Date de dépôt: 12.11.2019
(51) Int. Cl.: H01L 39/22, H01L 39/24, H01L 21/8238

(54) **TRANSISTOR A BLOCS DE SOURCE ET DE DRAIN SILICIURES PROCHES DU CANAL**
TRANSISTOR MIT SOURCE- UND DRAINBLOCK AUS SILIZID IN DER NÄHE DES KANALS
TRANSISTOR WITH SILICIDE SOURCE AND DRAIN BLOCKS NEAR THE CHANNEL

(30) Priorité: 14.11.2018 FR 1860511
(43) Date de publication de la demande: 20.05.2020
(73) Titulaire: Commissariat à l'énergie atomique et aux énergies alternatives, 75015 Paris (FR)
(72) Inventeur: NEMOUCHI, Fabrice, 38054 GRENOBLE CEDEX 09 (FR); LACERDA SANTOS NETO, Antonio, 38054 GRENOBLE CEDEX 09 (FR); LEFLOCH, François, 38054 GRENOBLE CEDEX 09 (FR)
(74) Mandataire: Brevalex

(56) Documents cités:
- EP-A1- 2 045 837
- US-A1- 2014 147 982

## Description

### DOMAINE TECHNIQUE ET ÉTAT DE LA TECHNIQUE ANTÉRIEURE

La présente demande a trait au domaine des transistors et plus particulièrement à celui de la mise en œuvre de transistors dotés de zones de source et de drain à base d'un composé de métal et de semi-conducteur.

Elle s'applique notamment à la réalisation de transistors dotés de zones de source et de drain en matériau susceptible d'avoir des propriétés supraconductrices. Elle s'applique également à la mise en œuvre de transistors à jonction de type Josephson réalisée entre une région de composé de métal et de semi-conducteur, créant sous certaines conditions une couche supraconductrice et une couche semi-conductrice.

Le document « Metallic Source and Drain Module for FDSOI MOSFETs Applications », de Carron et al., 2010 International Workshop on Junction Technology Extended Abstracts prévoit par exemple de réaliser un transistor doté de régions de source et de drain siliciurées à base de PtSi. Un autre exemple c'est trouve dans le brevet US 2014/147982.

Afin de limiter la résistance de régions d'accès au canal du transistor, on peut chercher à rapprocher autant que possible les interfaces entre les régions siliciurées et la structure de canal semi-conductrice. Pour cela, on met typiquement en œuvre une siliciuration latérale de portions semi-conductrices situées sous les espaceurs isolants. Or, cette siliciuration latérale ayant une cinétique élevée, il est difficile de pouvoir contrôler précisément son arrêt. Par ailleurs, on souhaite éviter de siliciurer une zone située en regard de l'électrode de grille et normalement dédiée à la structure de canal.

On cherche donc un nouveau procédé de réalisation de zones de source et de drain en composé de métal et de semi-conducteur et qui soit amélioré vis-à-vis d'inconvénients mentionnés ci-dessus.

### EXPOSÉ DE L'INVENTION

Un mode de réalisation de la présente invention prévoit ainsi un procédé de réalisation d'un transistor comprenant :
- réaliser sur un substrat doté d'une couche semi-conductrice superficielle dans laquelle une zone active est apte à être formée un bloc de grille agencé sur cette zone active,
- former des zones de protection latérales contre des faces latérales dudit bloc de grille,
- déposer au moins une couche de matériau métallique de sorte à recouvrir le bloc de grille, les zones de protection latérales et la zone active et effectuer au moins un premier recuit thermique de manière à former, dans la zone active, des régions à base de composé de matériau métallique et de matériau semi-conducteur de part et d'autre de la grille et dans le prolongement d'une portion située en regard du bloc de grille, cette portion semi-conductrice étant apte à former un canal de transistor, ledit recuit thermique étant prévu, en particulier en termes de durée, de sorte qu'une interface entre la ou les régions à base de composé de matériau métallique et de matériau semi-conducteur et ladite portion semi-conductrice est située à l'aplomb des zones de protection latérales ou sous et en regard des zones de protection latérales, les régions à base de composé de matériau métallique et de matériau semi-conducteur étant aptes à former respectivement des régions de source et de drain de transistor, puis,- former des espaceurs isolants de part et d'autre de la grille et reposant sur lesdites régions à base de composé de matériau métallique et de matériau semi-conducteur.

On évite ou on limite ainsi un processus de siliciuration latérale et l'on privilégie une siliciuration de régions recouvertes de métal, ce qui permet de définir plus précisément l'interface entre régions siliciurées et structure de canal.

Avec un tel procédé, on forme ainsi les espaceurs après avoir réalisé les régions de source et de drain siliciurées, ce qui permet d'obtenir une interface entre ces régions et une portion semi-conductrice qui se situe au plus près de la zone de canal du transistor, sans toutefois empiéter dans une zone en regard de la grille.

Un tel procédé s'applique ainsi tout particulièrement aux transistors de dimensions réduites.

Avantageusement, après le premier recuit, on effectue un retrait du matériau métallique sélectivement au composé de métal et de semi-conducteur, puis au moins un autre recuit thermique permettant d'obtenir ou de compléter la formation du composé de métal et de semi-conducteur souhaité.

Typiquement, les espaceurs isolants sont réalisés contre et en contact des zones de protection latérales. Les zones de protection latérales sont typiquement disposées contre et en contact de la grille.

Le substrat peut être de type semi-conducteur sur isolant et muni d'une couche isolante sur laquelle repose ladite couche semi-conductrice superficielle. Dans ce cas, le recuit thermique est avantageusement prévu, en particulier en termes de durée, de sorte que ledit composé est formé de part et d'autre des zones de protection latérales sur toute l'épaisseur de la zone active, les régions à base d'un composé de matériau métallique et de matériau semi-conducteur pouvant être ainsi en contact avec la couche isolante du substrat.

Les zones de protection latérales ont typiquement une épaisseur plus faible que celle d'espaceurs isolants conventionnels et configurés pour empêcher un couplage électrostatique entre la grille et des régions ou contacts de source et de drain.

Les zones de protection latérales ont ainsi typiquement une faible épaisseur, qui peut être en particulier inférieure à 5 nm et de préférence comprise entre 1 nm et 2 nm. Les zones de protection latérales peuvent avoir une épaisseur uniforme sur les faces latérales du bloc de grille.

Les zones de protection latérales sont formées typiquement par dépôt conforme d'une couche de protection sur le bloc de grille puis, par gravure anisotrope de ladite couche de protection.

Le retrait de la couche de protection peut comprendre des étapes consistant à :
- implanter une partie de la couche de protection située sur une face supérieure du bloc de grille et des parties qui s'étendent de part et d'autre du bloc de grille parallèlement à la zone active et à la couche isolante du substrat, l'implantation étant de préférence réalisée à l'aide d'au moins un faisceau vertical qui s'étend parallèlement à une normale à un plan principal du substrat, puis
- graver sélectivement les parties implantées de la couche de protection.

La couche de protection peut être par exemple en nitrure de silicium.

Le matériau métallique utilisé pour former les régions de source et drain en composé de matériau métallique et de semi-conducteur peut être à base d'un terre-rare, ou à base d'au moins un des métaux suivants : Pt, de Nb, de Co, de V.

De tels matériaux peuvent, sous certaines phases, permettre de former des régions siliciurées susceptibles d'adopter un comportement supraconducteur ou proche d'un supraconducteur.

Selon un mode de réalisation particulier, la grille comporte au moins un sommet en semi-conducteur et préalablement à la formation de la couche de protection, on forme un masque dur sur une face supérieure du sommet du bloc de grille, le masque dur étant conservé lors du dépôt de la couche de matériau métallique de sorte à recouvrir le bloc de grille.

Dans ce cas, le procédé peut comprendre après formation des espaceurs isolants des étapes de :
- formation d'au moins une couche de masquage autour du bloc de grille et de sorte à dévoiler le masque dur,
- retrait du masque dur de sorte à dévoiler la face supérieure du bloc de grille,
- dépôt d'au moins une couche en métal ou alliage métallique sur la face supérieure du bloc de grille,
- effectuer au moins un recuit de manière à former une zone à base de composé de métal et de semi-conducteur sur ladite face supérieure du bloc de grille.

On effectue ensuite typiquement un retrait sélectif de portions restantes de la couche en métal ou en alliage métallique n'ayant pas réagi avec le matériau du bloc de grille.

La couche de masquage est avantageusement formée d'au moins une couche de mise en contrainte réalisée sur les espaceurs.

Les régions à base de composé de matériau métallique et de matériau semi-conducteur ont avantageusement des propriétés supraconductrices.

Un procédé tel que défini plus haut peut ainsi s'appliquer en particulier à la réalisation de transistor JOFTET (pour « Josephson Field Effect Transistor »).

Selon un autre aspect, la présente demande concerne une structure de transistor formée à l'aide d'un procédé tel que défini plus haut et comprenant:
- une zone active formée dans une couche semi-conductrice superficielle d'un substrat,
- un bloc de grille agencé sur cette zone active,
- des zones de protection contre des faces latérales dudit bloc de grille,
- des espaceurs isolants de part et d'autre des zones de protection et dudit bloc de grille et reposant sur lesdites régions à base de composé de matériau métallique et de matériau semi-conducteur,
- des régions à base de composé de matériau métallique et de matériau semi-conducteur de part et d'autre et dans le prolongement d'une portion de la zone active qui est située en regard du bloc de grille, cette portion semi-conductrice étant apte à former un canal de transistor, les régions à base d'un composé de matériau métallique et de matériau semi-conducteur formant respectivement des régions de source et de drain de transistor, une interface entre la ou les régions à base de composé de matériau métallique et de matériau semi-conducteur et ladite portion semi-conductrice étant située en regard des zones de protection ou à l'aplomb des zones de protection.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1R servent à illustrer un exemple de procédé amélioré de réalisation de zones de source et de drain à base de composé de matériau métallique et de semi-conducteur pour la mise en œuvre d'un transistor, en particulier de type JoFET ;
- la figure 2 sert à illustrer une étape lors de la réalisation de zones de protection latérales destinées à protéger la grille lors de la formation dudit composé ;
- les figures 3A-3B servent à illustrer une variante de réalisation de zones de source et de drain à base de composé de matériau métallique et de semi-conducteur;
- la figure 4 sert à illustrer une variante de réalisation dans laquelle les plots de contact de source et de drain sont réalisés préalablement à une siliciuration de la grille ou à son remplacement.
- les figures 5A-5B servent à illustrer une variante de réalisation dans laquelle la siliciuration de région de source et de drain peut être réalisée en même temps que celle de la grille.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « supérieure », « superficielle », « latérale » s'appliquent en considérant que la structure est orientée de la façon illustrée dans les figures.

### EXPOSÉ DÉTAILLÉ DE MODES DE RÉALISATION PARTICULIERS

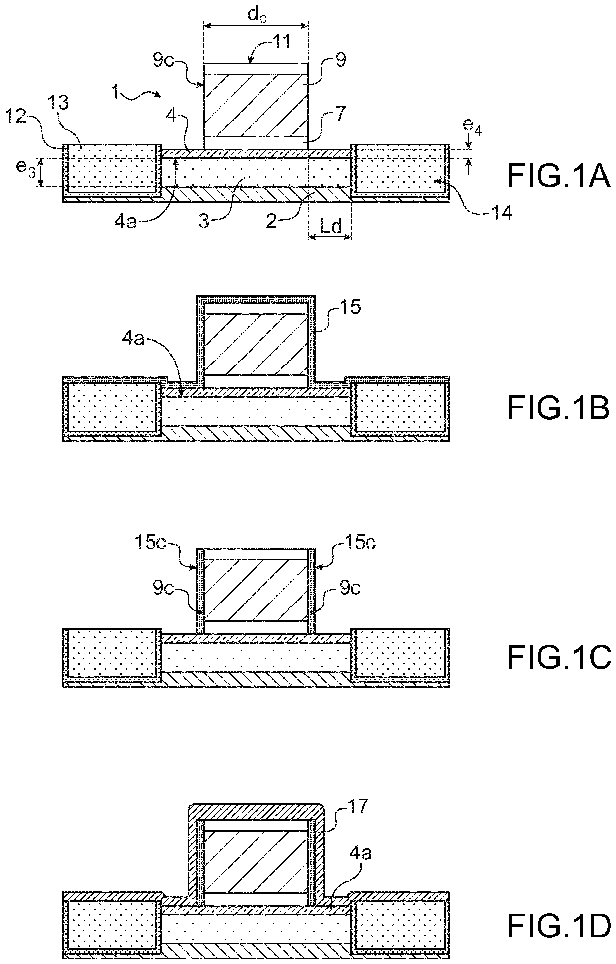

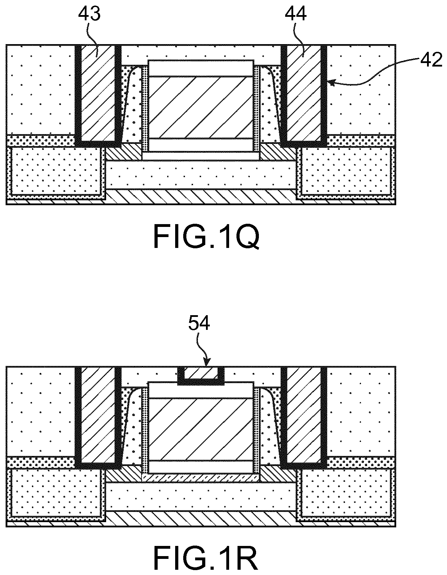

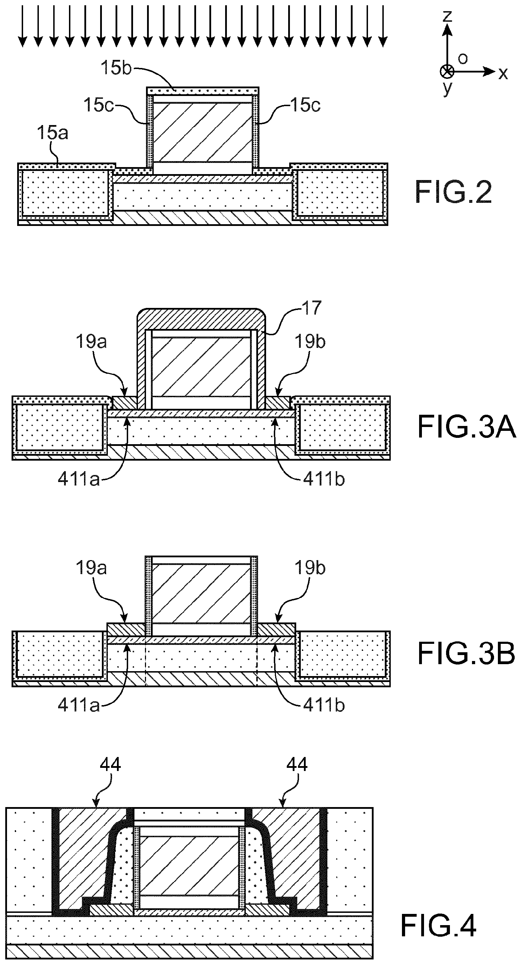

Un exemple de procédé de réalisation de zones de source et de drain en un composé de semi-conducteur et de métal et qui sont proches de la zone de canal va à présent être donné en liaison avec les figures 1A-1R et 2.

Le transistor réalisé peut être par exemple un transistor de type JoFET (« Josephson Field Effect Transistor ») autrement dit un transistor à effet de champ pour lequel le couplage entre deux régions de matériaux supraconducteurs peut être modulé par une grille électrostatique.

Dans l'exemple illustré sur la figure 1A, on forme ce transistor en partant d'un substrat 1 de type semi-conducteur sur isolant, en particulier un substrat de type SOI (« Silicon On Insulator » ou «silicium sur isolant »), avantageusement selon une technologie de semi-conducteur sur isolant totalement désertée également appelée FDSOI (pour « Fully Depleted Silicon On Insulator »).

Le substrat 1 comprend ainsi une couche de support 2 semi-conductrice revêtue d'une couche isolante 3, par exemple un oxyde de silicium enterré (BOX), recouvrant la couche de support 2, elle-même revêtue d'au moins une couche semi-conductrice 4 superficielle, par exemple en silicium.

L'épaisseur e₃ de la couche isolante 3 du substrat peut être comprise par exemple entre 10 et 50 nm, et en particulier entre 20 et 30 nm pour une technologie FDSOI. L'épaisseur e₄ de la couche semi-conductrice superficielle 4 peut être quant à elle comprise par exemple entre 3 et 30 nm, et en particulier entre 6 et 10 nm pour un transistor JoFET.

Dans la couche semi-conductrice superficielle 4, on définit une zone active 4a de transistor, dans cet exemple par gravure de sorte à retirer certaines portions de la couche semi-conductrice superficielle 4 et à dévoiler certaines zones de la couche la couche de support 2 situées autour de la zone active 4a.

Autour de la zone active 4a on réalise typiquement des zones d'isolation 14, en particulier de type STI (pour « Shallow trench isolation »). On peut pour cela déposer dans des tranchées autour de la zone active 4a, une couche isolante 12 formée par exemple d'un empilement d'oxyde de silicium et de nitrure silicium. Puis, un remplissage par du matériau isolant 13 tel que de l'oxyde de silicium est effectué. Ce remplissage peut être suivi d'une étape de planarisation CMP retirant le matériau isolant 13 en excès puis de retrait de la couche isolante 12 sur la zone active 4a.

La zone active 4a destinée à accueillir au moins une région de canal du transistor est recouverte d'un diélectrique 7 de grille par exemple à base de SiO₂ ou de HfO₂ et d'un matériau 9 de grille, par exemple à base de polysilicium dans lesquels on définit respectivement une zone de diélectrique de grille et un bloc de grille. Pour un transistor JoFET, on peut prévoir une grille de dimension critique dc (dimension mesurée parallèlement au plan [O ;x;y] du repère orthogonal [O ;x ;y ;z] donné sur la figure 1A) comprise par exemple entre 5 nm et 80 nm.

La zone active 4a dépasse du bloc de grille 9, de sorte que des régions dévoilées de la zone active 4a s'étendent de part et d'autre des faces latérales 9c de la grille. La longueur Ld de ce dépassement peut être comprise par exemple entre 10 nm et 100 nm.

Sur l'exemple de réalisation particulier de la figure 1A, le sommet, autrement dit la face supérieure du bloc de grille 9, est également revêtu d'un masque dur 11, par exemple à base de nitrure de silicium. Le masque dur 11 peut servir à définir le motif du bloc 9 de grille et peut être adapté pour former par la suite une protection, en particulier lors d'étapes ultérieures d'implantation et/ou de siliciuration.

Dans cet exemple de réalisation, après avoir défini le bloc de grille 9, on conserve ce masque dur 11. On forme ensuite des zones de protection contre des faces latérales 9c du bloc 9 de grille.

Pour cela, on peut effectuer une oxydation des faces latérales 9c et réaliser ainsi par exemple des zones d'oxyde de polysilicium. Une épaisseur d'oxyde comprise par exemple entre 2 nm et 4 nm peut être obtenue sur les faces latérales 9c, ce qui correspond typiquement à une consommation de polySilicium de 1 nm à 2 nm. Une étape de désoxydation de la zone active 4a peut être ensuite effectuée. Cette désoxydation peut être mise en œuvre par le biais d'un procédé plasma, de préférence anisotrope, comme un plasma d'Ar. Une telle désoxydation permet de dévoiler des zones de source et de drain tout en conservant les faces latérales 9c couvertes d'oxyde de protection. Une telle étape de désoxydation peut, selon un mode de réalisation particulier, correspondre à une étape de nettoyage que l'on réalise ultérieurement, typiquement juste avant une étape de dépôt d'une couche métallique en vue d'une siliciuration des zones de source et de drain.

Alternativement, et de manière avantageuse, la réalisation des zones de protection latérales comprend le dépôt d'une fine couche 15 de protection, de sorte à recouvrir le bloc 9 de grille (figure 1B). On réalise de préférence un dépôt conforme, de manière à avoir une épaisseur sensiblement uniforme au-dessus et sur les faces latérales de la grille 9. Dans ce cas, la fine couche 15 de protection peut être par exemple en nitrure de silicium (Si_{X}N_{y}).

On effectue ensuite une gravure (figure 1C), de préférence anisotrope de la couche de protection 15 de sorte à ne conserver cette couche 15 que sur et en contact des faces latérales 9c du bloc de grille et réaliser ainsi des zones de protection latérales 15c.

Ces zones de protection latérales 15c sont typiquement formées avec une épaisseur inférieure à celle que l'on prévoit habituellement pour réaliser des espaceurs, autrement dit des blocs susceptibles d'empêcher un couplage électrostatique entre d'une part la grille et d'autre part les contacts et/ou les régions de source et de drain. L'épaisseur de la couche de protection 15 peut être prévue par exemple entre 1 nm et 5 nm, de préférence entre 1 et 2 nm.

Une manière de réaliser la gravure anisotrope de la couche de protection 15 consiste, comme illustré sur la figure 2, à effectuer tout d'abord une implantation de régions 15a, 15b de la couche de protection 15 afin de modifier la composition de ces régions et pouvoir réaliser ensuite un retrait sélectif de ces régions vis-à-vis de zones de cette couche de protection 15 que l'on souhaite conserver. Par exemple, on effectue une implantation d'hélium ou d'hydrogène dans la couche de protection 15.

En réalisant une implantation à l'aide d'un faisceau orienté parallèlement à une normale n à un plan principal du substrat (plan défini comme passant par le substrat et parallèle au plan [0 ;x ;y] du repère orthogonal [O ;x ;y ;z] donné sur la figure 2), on peut modifier la composition d'une région 15b de la couche de protection située sur une face supérieure de la grille et de régions 15a recouvrant le substrat et/ou la zone active, tout en préservant des zones 15c qui s'étendent contre les flancs ou faces latérales de la grille 9. Les régions 15a, 15b de composition modifiée peuvent ensuite être retirées par gravure humide. Par exemple, le retrait sélectif de nitrure de silicium implanté à l'hydrogène ou à l'hélium peut être réalisé comme dans le document « Alternative process for thin layer etching :Application to nitride spacer etching stopping on silicon germanium », de Posseme et al., APPLIED PHYSICS LETTERS 105, 051605 (2014) à l'aide d'acide phosphorique (H₃PO₄) chaud ou de HF.

Après formation des zones 15c de protection latérales, on effectue un dépôt d'une couche de matériau métallique 17 (figure 1D) en vue de réaliser des zones de composé ou d'alliage à base de métal et de semi-conducteur. Un nettoyage préalable du substrat et de la zone active 4a peut être prévu, par exemple à l'aide de HF et/ou plasma Ar, He, en particulier afin d'éviter la présence de zones oxydées entre la couche métallique 17 et la zone active 4a semi-conductrice.

Le matériau métallique 17 est apte à former un composé de métal et de semi-conducteurtel qu'un siliciure. Le matériau métallique peut être en particulier un terre rare ou à base d'au moins un métal choisi parmi les métaux suivant : Pt, V, Co, Nb. Avantageusement, on choisit dans cet exemple de réalisation un siliciure susceptible, sous certaines phases, d'avoir des propriétés d'un supraconducteur.

La couche métallique 17 est typiquement déposée sur toute la surface du substrat, et en particulier recouvre les régions de la zone active 4a qui sont dévoilées et dépassent de part et d'autre des zones de protections 15c latérales.

On effectue alors au moins un recuit thermique permettant de former un composé entre le métal de la couche métallique 17 et le matériau semi-conducteur de la zone active 4a. On peut prévoir en particulier au moins un recuit rapide RTA (RTA pour « Rapid Thermal Anneal ») et/ou au moins un recuit laser.

Par exemple, pour une zone active 4a d'épaisseur de 25 nm et lorsque la couche 17 est en 10 nm, on peut prévoir un recuit de type RTA à une température qui peut être comprise entre 450°C et 550°C, selon une durée qui peut être prévue par exemple entre 10 s et 120 s.

Les zones de protection 15c latérales disposées entre la couche métallique 17 et la grille 9 permettent de préserver la grille 9 et d'empêcher la formation de composé sur les faces latérales de la grille 9. De même, dans cet exemple de réalisation particulier où l'on conserve un masque dur 11 sur la face supérieure de la grille 9, on empêche lors de cette étape la formation d'un composé sur la face supérieure de la grille 9.

Des régions semi-conductrices de la zone active 4a dépassant de part et d'autre des faces latérales de la grille sont ainsi transformées en régions 19a, 19b de composé de métal et de semi-conducteur, telles que des régions de siliciure et en particulier un composé ou un siliciure susceptible d'avoir un comportement supra-conducteur ou proche de celui d'un supra-conducteur. Par exemple, on forme des régions 19a, 19b, à base d'un siliciure de platine (PtSi), ou de siliciure de cobalt (CoSi₂), ou de siliciure de Vanadium (V₃Si), ou de siliciure de Niobium (NbSi₂), ou de siliciure de tungstène WSi₂.

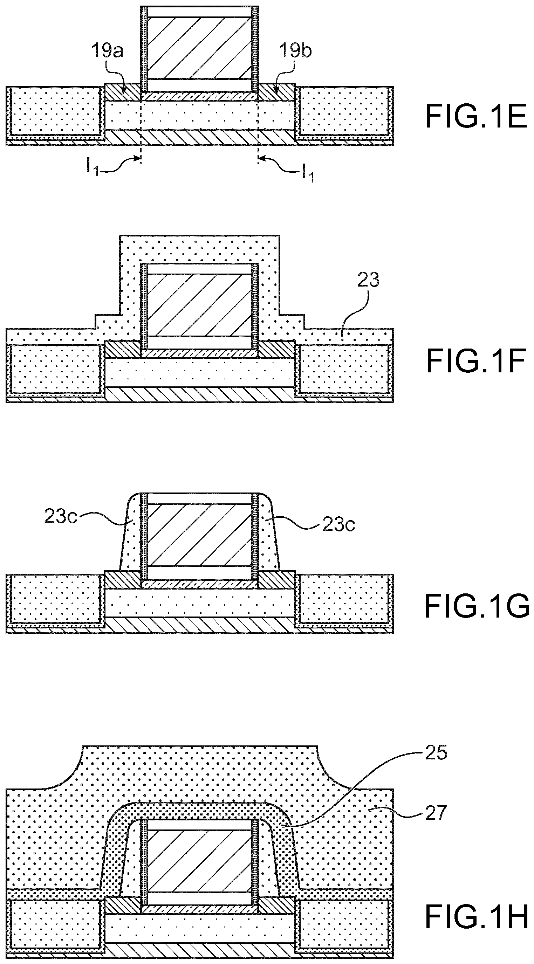

Dans l'exemple illustré sur la figure 1E, les régions semi-conductrices de la zone active 4a dépassant de part et d'autre des zones de protection 15c sont consommées sur toute leur épaisseur et sont ainsi transformées sur toute leur épaisseur en régions 19a, 19b de composé de métal et de semi-conducteur.

On peut ensuite effectuer un retrait par gravure sélective du matériau métallique 17 n'ayant pas réagi. Par exemple, afin de retirer du Pt ou du Co, on peut utiliser un procédé à base d'eau régal (HNO₃:HCl) ou de SPM (H₂SO₄:H₂O₂:H₂O) respectivement.

Ces régions 19a, 19b sont aptes à former des blocs de source et de drain pour le transistor. Du fait notamment de l'épaisseur très fine des zones de protection latérales 15c formées sur les faces latérales de la grille 9 et reposant sur la zone active 4a, les régions 19a, 19b de composé de métal et de semi-conducteur sont très proches d'une portion de la couche semi-conductrice superficielle 4 qui est située en regard de la grille 9.

L'interface I₁ entre les régions de composé de métal et de semi-conducteur et la portion restante de matériau semi-conducteur non consommé de la couche semi-conductrice 4 superficielle se situe, comme sur la figure 1E, dans le prolongement d'une face externe des zones 15c de protection latérales ou éventuellement sous ces zones 15c de protection latérales. Par « face externe », on entend une face opposée à celle qualifiée « d'interne » qui est disposée contre les flancs de la grille 9. On prévoit de préférence les conditions de recuit et en particulier la durée, de sorte que cette interface I₁ ne déborde pas en regard du bloc de grille. Dans la mesure où on limite ici le phénomène de siliciuration latérale, ces conditions sont plus aisées à déterminer et le positionnement de l'interface I₁ plus aisé à définir. Ainsi, au contraire d'un procédé où l'on viendrait réaliser des blocs de source et de drain siliciurés après avoir formé des espaceurs, on limite ici une croissance latérale et on évite d'avoir à réaliser une telle croissance latérale sous les espaceurs, ce qui permet de rendre plus aisé un positionnement précis de l'interface I₁ entre régions de composé et portion restante de matériau semi-conducteur. Cela peut permettre également d'obtenir une interface I₁ avec une résistance de contact plus faible.

Après avoir formé des blocs de source et drain en composé de métal et de semi-conducteur, on peut ensuite réaliser des espaceurs isolants 23c sur ces blocs.

Comme on peut le voir sur la figure 1E, les espaceurs 23c sont formés de préférence contre, et en contact des zones de protection 15c latérales, typiquement par dépôt de matériau(x) diélectrique(s) 23, puis par gravure(s). L'épaisseur de matériau diélectrique déposée pour réaliser les espaceurs 23c est typiquement supérieure à celle des zones d'isolation latérales 15c préservées sur les flancs latéraux de la grille et peut être prévue par exemple entre 5 nm et 50 nm en respectant au minimum la dimension Ld/2.

Dans l'exemple de la figure 1F, les espaceurs 23c sont formés d'une couche de matériau diélectrique tel que du nitrure de silicium, que l'on vient ensuite graver (figure 1G), par exemple à l'aide d'un plasma. En variante, on peut prévoir un bi-couches comportant par exemple une couche d'oxyde de silicium recouverte d'une couche de nitrure de silicium.

De manière optionnelle, on peut ensuite prévoir de réaliser une zone de composé de métal et de semi-conducteur sur la face supérieure du bloc de grille 9, ainsi que des plots de connexion pour prendre un contact électrique sur le bloc de source, le bloc de drain et le bloc de grille.

Pour cela, selon un mode de réalisation, on recouvre la structure de transistor en cours de réalisation d'au moins une couche isolante 27, par exemple d'oxyde de silicium, en particulier de type PMD (« pre-metal dielectric ») réalisé en un ou plusieurs dépôts.

Dans l'exemple de réalisation illustré sur la figure 1H, on forme au préalable une couche d'arrêt de gravure 25 sur des portions dévoilées de la couche isolante 3 du substrat ainsi que sur la structure de transistor. La couche d'arrêt de gravure 25 peut être à base d'un matériau apte à mettre en contrainte le transistor. Ce matériau est par exemple du nitrure de silicium contraint en tension ou en compression et qui peut également servir d'arrêt à une gravure d'oxyde de silicium.

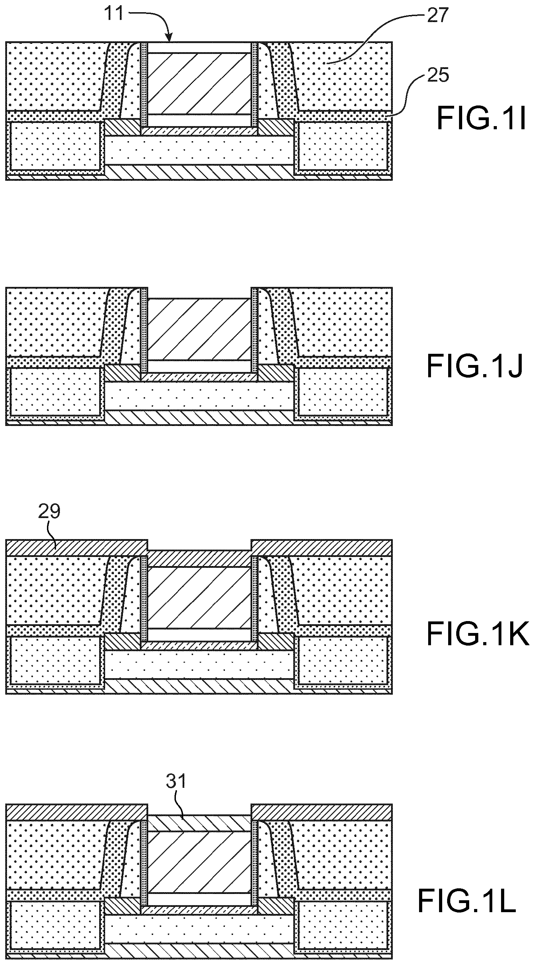

Une fois avoir déposé la couche isolante 27, on peut effectuer un aplanissement par polissage CMP, de manière à dévoiler le masque dur 11 (figure 1I).

On effectue ensuite, un retrait du masque dur 11, afin de dévoiler la grille 9, tandis que le reste de la structure est typiquement protégé par la couche isolante 27 (figure 1J). Le retrait est réalisé par exemple à l'aide de solution à base de H₃PO₄ lorsque le masque dur 11 est en nitrure de silicium.

Puis, on forme une zone à base de composé de métal et de semi-conducteur sur ladite face supérieure du bloc 9 de grille. Pour cela, un procédé comprend le dépôt d'au moins un métal 29 tel que par exemple du Nickel ou un alliage métallique, par exemple un alliage de Ni et de Pt (figure 1K). Le dépôt peut être réalisé à basse température, c'est-à-dire à une température inférieure à 550°C.

On réalise ensuite au moins un recuit thermique de sorte à former un composé 31 de métal et de semi-conducteur sur la face supérieure du bloc 9 de grille (figure 1L). Lorsque la grille est en polysilicium, le composé 31 est un siliciure sur polysilicium.

Par exemple, lorsque le matériau 29 est en NiPt (10%), on peut prévoir un recuit à une température qui peut être comprise entre 200°C et 300°C, selon une durée qui peut être prévue par exemple entre 10s et 60s.

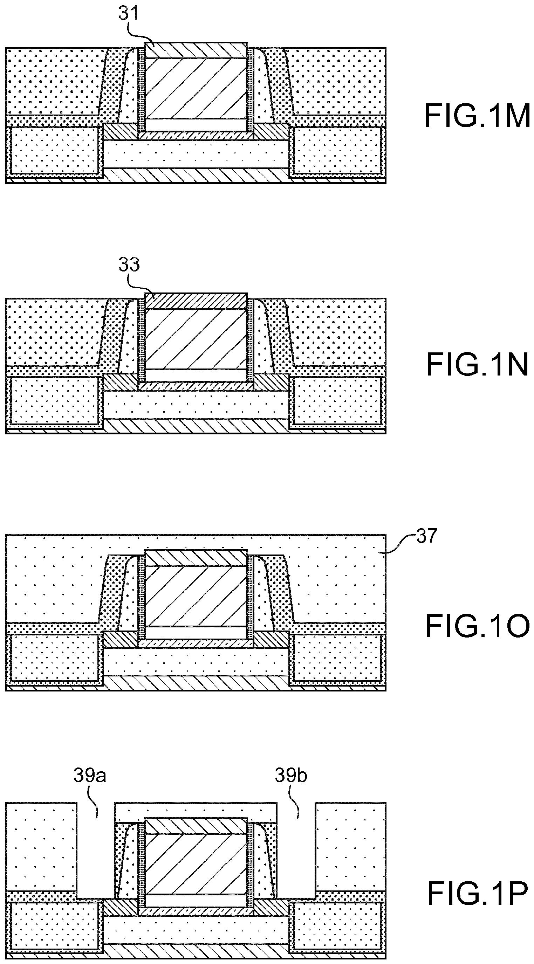

On peut ensuite (figure 1M) réaliser un retrait par gravure sélective du matériau métallique 29 n'ayant pas réagi. Par exemple, afin de retirer du NiPt, on peut utiliser un procédé à base d'une solution SPM pour « Sulfuric Peroxide Mixture » à base d'acide sulfurique peroxyde et d'eau.

Dans l'exemple de réalisation particulier illustré figure 1N, on effectue au moins un nouveau recuit de siliciuration de sorte à transformer le composé 31 de métal et de semi-conducteur en un composé 33 des mêmes éléments, mais selon une phase ou proportion atomique différente et moins résistive.

Par exemple, lorsque le composé 31 est du (NiPt)₂Si, on peut prévoir un recuit à une température qui peut être comprise entre 350 °C et 500 °C, selon une durée qui peut être prévue par exemple entre 1 s et 60 s afin de former un composé NiPtSi.

Une telle option de mise en œuvre, dans laquelle on forme un contact de grille indépendamment des contacts de source et de drain et dans lequel des composés de métal et de semi-conducteur différents peuvent être prévus entre la grille d'une part et les régions de source et de drain d'autre part, peut être prévue en particulier pour des raisons de coût, ou d'épaisseur des siliciures.

Une fois la zone de composé 33 réalisée sur le bloc de grille, on peut recouvrir la structure en cours de réalisation d'au moins une couche isolante 37, par exemple d'oxyde de silicium (figure 1O).

On forme ensuite des trous 39a, 39b à travers les couches isolantes 37, 27, 25, de sorte à dévoiler les régions 19a, 19b en composé de métal et de semi-conducteur (figure 1P). Puis, on forme dans ces trous 39a, 39b au moins un matériau conducteur de sorte à former des plots de contact.

Dans l'exemple de réalisation particulier illustré sur la figure 1O, des plots de contacts 44 sont réalisés par dépôt d'une fine couche 42 barrière de diffusion de métal, par exemple en TiN ou en TaN, tapissant les parois verticales et le fond des trous 39a, 39b.

Puis, on effectue un remplissage du reste des trous 39a, 39b à l'aide d'un métal 43 tel que par exemple du W.

En variante, la fine couche barrière de diffusion 42 peut être remplacée par une couche de tungstène (W^{∗}) sans Fluor telle que cela est décrit par exemple dans le document « Advanced characterizations of fluorine-free tungsten film and its application as low résistance liner for PCRAM », de Rodriguez et al., Materials Science in Semiconductor Processing 71 (2017) 433-440. La fine couche de Tungstène est ici déposée sans faire appel à un précurseur fluoré par exemple tel que le WF₆. Puis, on peut compléter le remplissage par un dépôt conventionnel de métal 43 tel que du tungstène.

Avantageusement, on peut utiliser un matériau de remplissage également susceptible d'avoir des propriétés supra-conductrices choisi par exemple parmi : Al, TiN, V ou Nb afin de conserver une continuité supraconductrice vers d'autres composants.

Dans l'exemple de réalisation particulier illustré sur la figure 1R, un plot de contact 54 est également formé sur la grille, typiquement à l'aide des mêmes matériaux que les plots de contacts 44 de source et de drain.

Dans le cas où le transistor que l'on réalise est de type JoFET, autrement dit à jonctions Josephson, celui-ci est amené à être placé à une température telle que ses régions de composé de métal et de semi-conducteur 19a, 19b et dans lesquelles des source et drain sont formées, adoptent un comportement supra-conducteur.

Par exemple un siliciure de Platine, en particulier du PtSi, peut avoir un comportement supraconducteur à une température inférieure à une température critique de l'ordre de 0.5 ou 1K. Un siliciure de cobalt, en particulier du CoSi₂, peut avoir un comportement supraconducteur à une température inférieure à une température critique comprise entre 1 et 3K. Un siliciure de vanadium, en particulier du V₃Si, peut avoir un comportement supraconducteur à une température inférieure à une température critique de l'ordre de 15 K. On envisage de placer un transistor tel que décrit précédemment à une température par exemple comprise entre 10K et 15 mK.

Une variante de l'exemple de procédé décrit précédemment et plus particulièrement de la formation des régions 19a, 19b de composé de métal et de semi-conducteur est illustrée sur les figures 3A-3B. Pour cette variante, les régions 19a, 19b de composé de métal peuvent être formées en plusieurs étapes de propagation du siliciure, et en particulier en plusieurs recuits.

Après avoir effectué le dépôt d'au moins une couche de matériau métallique 17, on effectue alors un premier recuit thermique permettant de former un composé entre le métal de la couche métallique 17 et le matériau semi-conducteur de la zone active 4a.

Dans l'exemple de réalisation illustré sur la figure 3A, des régions semi-conductrices 41a de la zone active 4a dépassant de part et d'autre des faces latérales de la grille sont partiellement transformées en régions 19a, 19b de composé de métal et de semi-conducteur. La durée du recuit est en particulier prévue de sorte que des zones semi-conductrices 411a, 411b sont préservées sous les régions 19a, 19b de composé de métal et de semi-conducteur. Ainsi, à l'issue du recuit réalisé sous les régions 19a, 19b de composé de métal et de semi-conducteur, par exemple en PtSi, ou CoSi₂, ou V₃Si, ou NbSi₂, on conserve dans cet exemple de réalisation un épaisseur de matériau semi-conducteur, en particulier de silicium.

On peut ensuite retirer le métal 17 (figure 3B). Une gravure sélective du matériau métallique 17 n'ayant pas réagi est ainsi réalisée. Par exemple, afin de retirer du Pt ou Co, on peut utiliser un procédé à base d'eau régale (HNO₃:HCl) ou de SPM (H₂SO₄:H₂O₂:H₂O) respectivement.

On peut ensuite effectuer au moins un deuxième recuit thermique de sorte à étendre les régions de composé de métal et de semi-conducteur.

Cet autre recuit thermique est réalisé alors de sorte à étendre les régions 19a, 19b de composé de métal et de semi-conducteur et transformer ainsi les zones 411a, 411b en zones de composé de métal et de semi-conducteur. Cet autre recuit thermique est effectué de préférence de manière à former des régions de composé de métal et de semi-conducteur qui, comme illustré sur la figure 1E s'étendent sur toute l'épaisseur de la zone active 4a. Avec une telle variante on évite la pénétration de siliciure dans le canal grâce à un premier recuit réalisé à plus basse température.

Dans l'un ou l'autre des exemples de réalisation donnés précédemment, la grille contre laquelle on forme les zones de protection latérales 15c et les espaceurs 23c peut être une grille définitive et sur laquelle on réalise une zone de contact électrique.

Selon une variante du procédé décrit précédemment, on peut réaliser un remplacement de la grille selon une méthode de type appelée « gate last ».

Dans l'exemple de réalisation illustré sur la figure 4, des plots de connexion 44 pour la source et le drain sont réalisés avant une siliciuration de la grille.

Dans ce cas, on peut déposer une couche diélectrique supplémentaire permettant d'isoler les plots de contacts du métal utilisé pour la siliciuration de la grille.

Selon une variante de réalisation de l'un ou l'autre des procédés qui viennent d'être décrits, on peut prévoir de réaliser sur la grille un composé ou siliciure de même type que celui formé pour les régions de source et de drain.

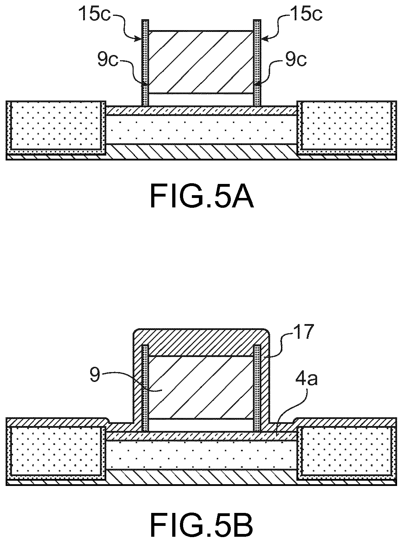

Dans ce cas, l'étape de réalisation du composé, en particulier par siliciuration peut être effectuée sur la grille et les sources et drains simultanément. Un retrait du masque dur est ainsi réalisé (figure 5A) avant dépôt métallique de siliciuration (figure 5B).

La présente invention trouve des applications dans le domaine des transistors pour dispositifs à processeur quantique tels que les calculateurs quantiques ou les ordinateurs quantiques, autrement dit avec des composants travaillant sur des qubits dont l'état quantique peut posséder plusieurs valeurs.

Toutefois l'un ou l'autre des exemples de procédés de réalisation qui viennent d'être décrits peuvent également s'appliquer à la mise en œuvre d'autres types de transistors et notamment à la réalisation de transistors MOS susceptibles d'être placés à des températures de fonctionnement conventionnelles.

## Revendications

1. Procédé de réalisation d'un transistor comprenant les étapes suivantes :
- réaliser sur un substrat doté d'une couche semi-conductrice superficielle (4) dans laquelle une zone active (4a) est apte à être formée : un bloc de grille (9) agencé sur cette zone active,
- former des zones de protection (15c) latérales contre des faces latérales dudit bloc (9) de grille,
- déposer au moins une couche de matériau métallique (17) de sorte à recouvrir le bloc (9) de grille, les zones de protection (15c) et la zone active (4a) et effectuer au moins un recuit thermique de manière à former, dans la zone active, des régions (19a, 19b) à base de composé de matériau métallique et de matériau semi-conducteur de part et d'autre de la grille et dans le prolongement d'une portion située en regard du bloc de grille, cette portion semi-conductrice étant apte à former un canal de transistor, ledit recuit thermique étant prévu, en particulier en termes de durée, de sorte qu'une interface (I1) entre la ou les régions (19a, 19b) à base de composé de matériau métallique et de matériau semi-conducteur et ladite portion semi-conductrice est située à l'aplomb des zones de protection latérales (15c) ou sous et en regard des zones de protection latérales (15c), les régions (19a, 19b) à base de composé de matériau métallique et de matériau semi-conducteur étant aptes à former respectivement des régions de source et de drain de transistor, puis,
- former des espaceurs isolants (23c) de part et d'autre de la grille et reposant sur lesdites régions à base de composé de matériau métallique et de matériau semi-conducteur.

2. Procédé selon la revendication 1, les espaceurs isolants étant réalisés contre et en contact des zones de protection (15c) latérales.

3. Procédé selon l'une des revendications 1 ou 2, dans lequel ledit substrat est de type semi-conducteur sur isolant et muni d'une couche isolante (3) sur laquelle repose ladite couche semi-conductrice superficielle (4), ledit recuit thermique est prévu, en particulier en termes de durée, de sorte que ledit composé est formé de part et d'autre des zones de protection latérales sur toute l'épaisseur de la zone active, les régions à base d'un composé de matériau métallique et de matériau semi-conducteur étant ainsi en contact avec la couche isolante du substrat.

4. Procédé selon l'une des revendications 1 à 3, dans lequel les zones de protection latérales (15c) ont une faible épaisseur, qui est inférieure à 5 nm, et de préférence comprise entre 1 et 2 nm.

5. Procédé selon l'une des revendications 1 à 4, dans lequel les zones de protection latérales (15c) ont une épaisseur uniforme sur les faces latérales du bloc (9) de grille.

6. Procédé selon l'une des revendications 1 à 5, dans lequel les zones de protection latérales (15c) sont formées par dépôt conforme d'une couche (15) de protection sur le bloc de grille, puis retrait anisotrope de ladite couche de protection.

7. Procédé selon la revendication 6, dans lequel la couche de protection de protection est en particulier en nitrure de silicium, le retrait anisotrope de la couche de protection comprend des étapes de :
- implantation, en particulier d'hélium ou d'hydrogène, d'une partie (15b) de la couche de protection située sur une face supérieure du bloc de grille et de parties (15a) qui s'étendent de part et d'autre du bloc (9) de grille parallèlement à la zone active et à la couche isolante du substrat, l'implantation étant de préférence réalisée à l'aide d'au moins un faisceau vertical qui s'étend parallèlement à une normale à un plan principal du substrat,
- gravure sélective des parties (15a, 15b) implantées de la couche de protection.

8. Procédé selon l'une des revendications 1 à 7, dans lequel la grille comporte au moins un sommet en semi-conducteur et dans lequel préalablement à la formation de la couche de protection (15), on forme un masque dur (11) sur une face supérieure du sommet du bloc (9) de grille, le masque dur (11) étant conservé lors du dépôt de la couche de matériau métallique (17) de sorte à recouvrir le bloc de grille, les zones de protection (15c) et la zone active (4a), le procédé comprenant après formation des espaceurs isolants (23c) :
- formation d'au moins une couche de masquage (25-27) autour du bloc de grille et de sorte à dévoiler le masque dur,
- retrait du masque dur (11) de sorte à dévoiler la face supérieure du bloc (9) de grille,
- déposer au moins une couche en métal ou alliage métallique sur la face supérieure du bloc de grille,
- effectuer au moins un recuit de manière à former une zone (31) à base de composé de métal et de semi-conducteur sur ladite face supérieure du bloc de grille.

9. Procédé selon la revendication 8, dans lequel la couche de masquage est formée d'au moins une couche de mise en contrainte réalisée sur les espaceurs.

10. Procédé selon l'une des revendications 1 à 9, dans lequel le matériau métallique est à base de Pt, de Nb, de Co, de V ou d'un Terre-rare.

11. Procédé selon l'une des revendications 1 à 10, dans lequel les régions (19a, 19b) à base de composé de matériau métallique et de matériau semi-conducteur aptes à adopter des propriétés supraconductrices.

12. Structure de transistor comprenant:
- une zone active formée dans une couche semi-conductrice superficielle d'un substrat,
- un bloc de grille agencé sur cette zone active,
- des zones de protection latérales contre des faces latérales dudit bloc de grille,
- des régions à base de composé de matériau métallique et de matériau semi-conducteur de part et d'autre et dans le prolongement d'une portion de la zone active qui est située en regard du bloc de grille, cette portion semi-conductrice étant apte à former un canal de transistor, les régions à base d'un composé de matériau métallique et de matériau semi-conducteur formant respectivement des régions de source et de drain de transistor,
- des espaceurs isolants de part et d'autre de la grille et reposant sur lesdites régions à base de composé de matériau métallique et de matériau semi-conducteur, dans lequel une interface entre la ou les régions à base de composé de matériau métallique et de matériau semi-conducteur et ladite portion semi-conductrice est située à l'aplomb des zones de protection latérales (15c) ou sous et en regard des zones de protection (15c) latérales (15c).

13. Structure de transistor selon la revendication 12, les espaceurs isolants étant disposés en contact desdites zones de protection.

14. Structure de transistor selon l'une des revendications 12 ou 13, dans lequel ledit substrat est de type semi-conducteur sur isolant et muni d'une couche isolante (3) sur laquelle repose ladite couche semi-conductrice superficielle (4), les régions à base de composé de matériau métallique et de matériau semi-conducteur étant agencées de part et d'autre des zones de protection latérales sur toute l'épaisseur de la zone active, les régions à base d'un composé de matériau métallique et de matériau semi-conducteur étant ainsi en contact avec la couche isolante du substrat.

15. Structure de transistor selon l'une des revendications 12 à 14, le transistor étant de type JoFET et/ou les régions (19a, 19b) à base de composé de matériau métallique et de matériau semi-conducteur ayant des propriétés supraconductrices.

## Patentansprüche

1. Verfahren zur Herstellung eines Transistors, umfassend die folgenden Schritte:
- Realisieren, auf einem dotierten Substrat, einer Oberflächenhalbleiterschicht (4), in der eine aktive Zone (4a) gebildet werden kann, wobei ein Gateblock (9) auf dieser aktiven Zone angeordnet ist,
- Bilden von seitlichen Schutzzonen (15c) gegen Seitenflächen des Gateblocks (9),
- Aufbringen wenigstens einer Schicht aus Metallmaterial (17) derart, dass der Gateblock (9), die Schutzzonen (15c) und die aktive Zone (4a) bedeckt werden, und Durchführen wenigstens eines thermischen Glühens derart, dass in der aktiven Zone Regionen (19a, 19b) auf Basis einer Verbindung aus Metallmaterial und aus Halbleitermaterial auf beiden Seiten des Gates und in der Verlängerung eines Bereichs gebildet werden, der sich gegenüber dem Gateblock befindet, wobei dieser Halbleiterbereich dazu ausgelegt ist, einen Transistorkanal zu bilden, wobei das thermische Glühen insbesondere hinsichtlich der Dauer derart vorgesehen ist, dass eine Grenzfläche (l1) zwischen der oder den Regionen (19a, 19b) auf Basis der Verbindung aus Metallmaterial und aus Halbleitermaterial und dem Halbleiterbereich sich lotrecht zu den seitlichen Schutzzonen (15c) oder unter und gegenüber den seitlichen Schutzzonen (15c) befindet, wobei die Regionen (19a, 19b) auf Basis der Verbindung aus Metallmaterial und aus Halbleitermaterial dazu ausgelegt sind, Source- bzw. Drainregionen des Transistors zu bilden, und dann
- Bilden von isolierenden Abstandhaltern (23c) auf beiden Seiten des Gates, die auf den Regionen auf Basis der Verbindung aus Metallmaterial und Halbleitermaterial ruhen.

2. Verfahren nach Anspruch 1, wobei die isolierenden Abstandhalter gegen und in Kontakt mit den seitlichen Schutzzonen (15c) realisiert werden.

3. Verfahren nach einem der Ansprüche 1 oder 2, wobei das Substrat vom Typ Halbleiter auf Isolator ist und mit einer isolierenden Schicht (3) ausgestattet ist, auf der die Oberflächenhalbleiterschicht (4) ruht, wobei das thermische Glühen insbesondere hinsichtlich der Dauer derart vorgesehen ist, dass die Verbindung auf beiden Seiten der seitlichen Schutzzonen über die gesamte Dicke der aktiven Zone gebildet wird, wobei die Regionen auf Basis der Verbindung aus Metallmaterial und aus Halbleitermaterial somit in Kontakt mit der isolierenden Schicht des Substrats sind.

4. Verfahren nach einem der Ansprüche 1 bis 3, bei dem die seitlichen Schutzzonen (15c) eine geringe Dicke haben, die kleiner als 5 nm ist, und vorzugsweise zwischen 1 und 2 nm enthalten ist.

5. Verfahren nach einem der Ansprüche 1 bis 4, bei dem die seitlichen Schutzzonen (15c) eine gleichförmige Dicke auf den Seitenflächen des Gateblocks (9) haben.

6. Verfahren nach einem der Ansprüche 1 bis 5, bei dem die seitlichen Schutzzonen (15c) durch konforme Aufbringung einer Schutzschicht (15) auf den Gateblock und anschließendes anisotropes Entfernen der Schutzschicht gebildet werden.

7. Verfahren nach Anspruch 6, bei dem die Schutzschicht insbesondere aus Siliciumnitrid ist, wobei das anisotrope Entfernen der Schutzschicht die folgenden Schritte umfasst:
- Implantation, insbesondere mittels Helium oder Wasserstoff, eines Teils (15b) der Schutzschicht, der sich auf einer oberen Fläche des Gateblocks befindet, und von Teilen (15a), die sich auf beiden Seiten des Gateblocks (9) parallel zur aktiven Zone und zur isolierenden Schicht des Substrats erstrecken, wobei die Implantation vorzugsweise mittels wenigstens eines vertikalen Strahls realisiert wird, der sich parallel zu einer Normalen auf eine Hauptebene des Substrats erstreckt,
- selektives Ätzen der implantierten Teile (15a, 15b) der Schutzschicht.

8. Verfahren nach einem der Ansprüche 1 bis 7, bei dem das Gate wenigstens eine Spitze aus Halbleiter umfasst, und wobei man vor dem Bilden der Schutzschicht (15) eine harte Maske (11) auf einer oberen Fläche der Spitze des Gateblocks (9) bildet, wobei die harte Maske (11) während der Aufbringung der Schicht aus Metallmaterial (17) bewahrt bleibt, derart, dass sie den Gateblock, die Schutzzonen (15c) und die aktive Zone (4a) bedeckt, wobei das Verfahren nach dem Bilden der isolierenden Abstandhalter (23c) folgendes umfasst:
- Bilden wenigstens einer Maskierungsschicht (25- 27) um den Gateblock herum und derart, dass die harte Maske freigelegt wird,
- Entfernen der harten Maske (11) derart, dass die obere Fläche des Gateblocks (9) freigelegt wird,
- Aufbringen wenigstens einer Schicht aus Metall oder Metalllegierung auf die obere Fläche des Gateblocks,
- Durchführen wenigstens eines Glühens derart, dass eine Zone (31) auf Basis der Verbindung von Metall und von Halbleiter auf der oberen Fläche des Gateblocks gebildet wird.

9. Verfahren nach Anspruch 8, wobei die Maskierungsschicht aus wenigstens einer Spannschicht gebildet wird, die auf den Abstandhaltern realisiert wird.

10. Verfahren nach einem der Ansprüche 1 bis 9, bei dem das Metallmaterial auf Basis von Pt, von Nb, von Co, von V oder von einer seltenen Erde ist.

11. Verfahren nach einem der Ansprüche 1 bis 10, bei dem die Regionen (19a, 19b) auf Basis der Verbindung aus Metallmaterial und aus Halbleitermaterial dazu ausgelegt sind, supraleitende Eigenschaften anzunehmen.

12. Transistorstruktur, umfassend:
- eine aktive Zone, die in einer Oberflächenhalbleiterschicht eines Substrats gebildet ist,
- einen Gateblock, der auf dieser aktiven Zone angeordnet ist,
- seitliche Schutzzonen gegen Seitenflächen des Gateblocks,
- Regionen auf Basis einer Verbindung aus Metallmaterial und aus Halbleitermaterial auf beiden Seiten und in der Verlängerung eines Bereichs der aktiven Zone, der sich gegenüber dem Gateblock befindet, wobei dieser Halbleiterbereich dazu ausgelegt ist, einen Transistorkanal zu bilden, wobei die Regionen auf Basis der Verbindung aus Metallmaterial und aus Halbleitermaterial Source- bzw. Drainregionen des Transistors bilden,
- isolierende Abstandhalter auf beiden Seiten des Gates, die auf den Regionen auf Basis der Verbindung aus Metallmaterial und aus Halbleitermaterial ruhen, wobei eine Grenzfläche zwischen der oder den Regionen auf Basis der Verbindung aus Metallmaterial und aus Halbleitermaterial und dem Halbleiterbereich sich lotrecht zu den seitlichen Schutzzonen (15c) oder unter und gegenüber den seitlichen Schutzzonen (15c) befindet.

13. Transistorstruktur nach Anspruch 12, wobei die isolierenden Abstandhalter in Kontakt mit den Schutzzonen angeordnet sind.

14. Transistorstruktur nach einem der Ansprüche 12 oder 13, wobei das Substrat vom Typ Halbleiter auf Isolator ist und mit einer isolierenden Schicht (3) ausgestattet ist, auf der die Oberflächenhalbleiterschicht (4) ruht, wobei die Regionen auf Basis der Verbindung aus Metallmaterial und aus Halbleitermaterial auf beiden Seiten der seitlichen Schutzzonen über die gesamte Dicke der aktiven Zone angeordnet sind, wobei die Regionen auf Basis der Verbindung aus Metallmaterial und aus Halbleitermaterial somit in Kontakt mit der isolierenden Schicht des Substrats sind.

15. Transistorstruktur nach einem der Ansprüche 12 bis 14, wobei der Transistor vom Typ JoFET ist, und/oder die Regionen (19a, 19b) auf Basis der Verbindung aus Metallmaterial und aus Halbleitermaterial supraleitende Eigenschaften haben.

## Claims

1. A method for producing a transistor comprising the steps of:
- producing, on a substrate provided with a semiconductor surface layer (4) wherein an active area (4a) is capable of being formed: a gate block (9) arranged on this active area,
- forming lateral protection (15c) areas against lateral faces of said gate block (9),
- depositing at least one layer of metal material (17) so as to cover the gate block (9), the protection areas (15c) and the active area (4a) and carrying out at least one thermal annealing so as to form, in the active area, regions (19a, 19b) based on metal material-semiconductor material compound on either side of the gate and in the continuation of a portion located facing the gate block, this semiconductor portion being capable of forming a transistor channel, said thermal annealing being provided, in particular in terms of duration, such that an interface (1) between the one or more regions (19a, 19b) based on a metal material-semiconductor material compound and said semi-conductor portion is located vertically to the lateral protection areas or beneath and facing the lateral protection areas (15c), the regions based on a metal material-semiconductor material compound being capable of respectively forming transistor source and drain regions, then
- forming insulating spacers (23c) on either side of the gate and resting on said regions based on a metal material-semiconductor material compound.

2. Method according to claim 1, wherein the insulating spacers are produced against and in contact with the lateral protection (15c) areas.

3. Method according to any of the claims 1 or 2, wherein said substrate is of the semiconductor-on-insulator type and is provided with an insulating layer (3) on which said semiconductor surface layer (4) rests, said thermal annealing is provided, in particular in terms of duration, such that said compound is formed on either side of the lateral protection areas over the entire thickness of the active area, whereby the regions based on a metal material-semiconductor material compound are thus in contact with the insulating layer of the substrate.

4. Method according to any of the claims 1 to 3, wherein the lateral protection areas (15c) have a low thickness, which is less than 5 nm, and preferably lies in the range 1 to 2 nm.

5. Method according to any of the claims 1 to 4, wherein the lateral protection areas (15c) have a uniform thickness on the lateral faces of the gate block (9).

6. Method according to any of the claims 1 to 5, wherein the lateral protection areas are formed by conformal deposition of a protection layer on the gate block then by anisotropic removal of said protection layer.

7. Method according to claim 6, wherein the protection layer is in particular made of silicon nitride, and whereby anisotropic removal of the protection layer comprises steps of:
- implanting, in particular by helium or hydrogen implantation, a part (15b) of the protection layer located on a top face of the gate block and parts (15a) which extend on either side of the gate block (9) parallel to the active area and to the insulating layer of the substrate, the implantation preferably being carried out using at least one vertical beam which extends parallel to a normal to a main plane of the substrate,
- selectively etching the implanted parts of the protection layer.

8. Method to any of the claims 1 to 7, wherein the gate includes at least one semiconductor tip and wherein, prior to the formation of the protection layer (15), a hard mask (11) is formed on a top face (9) of the tip of the gate block, the hard mask (11) being preserved during the deposition of the layer of metal material (17) in order to cover the gate block (9), the protection areas and the active area, the method comprising, after the formation of insulating spacers:
- forming at least one masking layer around the gate block and so as to reveal the hard mask,
- removing the hard mask (11) so as to reveal the top face of the gate block (9),
- depositing at least one metal or metal alloy layer on the top face of the gate block,
- carrying out at least one annealing so as to form an area (31) based on a metal-semiconductor compound on said top face of the gate block.

9. Method according to claim 8, wherein the masking layer is formed by at least one stressing layer produced on the spacers.

10. Method according to any of the claims 1 to 9, wherein the metal material is formed of Pt, Nb, Co, V or of a rare earth.

11. Method according any of the claims 1 to 10, wherein the regions (19a, 19b) based on a metal material-semiconductor material compound are capable of adopting superconducting properties.

12. Transistor structure comprising:
- an active area formed in a semiconductor surface layer of a substrate,
- a gate block arranged on this active area,
- lateral protection areas against lateral faces of said gate block,
- regions having a metal material-semiconductor material compound based on either side and in the continuation of a portion of the active area which is located facing the gate block, this semi-conductor portion being capable of forming a transistor channel, the regions based on a metal material-semiconductor material compound respectively forming transistor source and drain regions,
- insulating spacers on either side of the gate and resting on said regions based on a metal material-semiconductor material compound, wherein an interface between the one or more regions based on a metal material-semiconductor material compound and said semi-conductor portion is located vertically to the lateral protection areas (15c) or beneath and facing the lateral protection areas (15c).

13. Transistor structure according to claim 12, wherein the insulating spacers are disposed in contact with said protection areas.

14. Transistor structure according to any of claims 12 or 13, wherein said substrate is of the semiconductor-on-insulator type and is provided with an insulating layer (3) on which said semiconductor surface layer (4) rests, the regions based on a metal material-semiconductor material compound being arranged on either side of the lateral protection areas over the entire thickness of the active area, whereby the regions based on a metal material-semiconductor material compound are thus in contact with the insulating layer of the substrate.

15. Transistor structure according to any of the claims 12 to 14, wherein the transistor is of the JoFET type and/or the regions (19a, 19b) being based on a metal material-semiconductor material compound having superconducting properties.
